# EUROPÄISCHE PATENTANMELDUNG

(11) **EP 2 784 939 A1**
(43) Veröffentlichungstag der Anmeldung: **01.10.2014**
(21) Anmeldenummer: 13161389.5
(22) Anmeldetag: 27.03.2013
(51) Int. Cl.: H03K 17/96

(54) **Kapazitive Schalteinrichtung**

(71) Anmelder: RAFI GmbH & Co. KG, 88276 Berg (DE)
(72) Erfinder: Rausch, Andreas, 88212 Ravensburg (DE)
(74) Vertreter: Engelhardt & Engelhardt

(57) **Zusammenfassung**

Bei einer kapazitiven Schalteinrichtung (1) zur Umwandlung von punktuelle und/oder linearen Bewegungen eines Objektes (10) in elektrische Schaltsignale, bestehend
- aus einem Gehäuserahmen (2),
- aus einem in dem Gehäuserahmen (2) eingesetzten plattenförmigen Display (3) mit einer Vielzahl von Schaltfeldern (4),
- aus einem auf der Oberfläche (5) des Displays (3) aufgebrachten Trägermaterial (7), das transparent und elektrisch leitfähig ist und durch das ein Spannungs- oder Kapazitätsfeld (8) gebildet ist, das nach außen abstrahlt und das jedem der Schaltfelder (4) des Displays (3) zugeordnet ist und
- aus einer Leiterplatte (9), auf der Elektronikbauteile zur Auswertung der Spannungs- oder Kapazitäts-Veränderungen des Trägermaterials (7) vorgesehen sind und durch die elektrische Schaltsignale für jedes der Schaltfelder (4) generiert sind, soll die Schalteinrichtung (1) einen möglichst gering bemessenen und undurchsichtigen Randbereich aufweisen.

Dies wird dadurch erreicht, dass die elektrische Verbindung zwischen dem auf der Außenseite des Displays (3) aufgebrachten Trägermaterials (7) und der Leiterplatte (9) mittels eines biegeelastischen Leitgummis (11), vorzugsweise mittels eines Zebra-Leitgummis, geschaffen ist und dass jedes der Schaltfelder (4) des Trägermaterials (7) mittels des Leitgummis (11) an die Leiterplatte (9) angeschlossen ist.

## Beschreibung

Die Erfindung bezieht sich auf eine kapazitive Schalteinrichtung nach dem Oberbegriff des Patentanspruches 1.

Derartige kapazitive Schalteinrichtungen werden zur Steuerung von elektrischen Geräten, beispielsweise Mobiltelefonen, Werkzeugmaschinen oder medizintechnischen Geräten, verwendet. Dabei wird für jedes Schaltfeld ein Kapazität- oder Spannungsfeld von einem Trägermaterial, das auf dem Display aufgebracht ist, gebildet. Sobald durch eine mit dem elektrisch leitenden Trägermaterial verbundene Auswerteeinrichtung, die beispielsweise auf einer Leiterplatte im Inneren des von dem Display und dem Gehäuserahmen gebildet ist, festgestellt ist, wird durch die Auswerteeinrichtung ein elektrisches Schaltsignal erzeugt, das den jeweiligen in dem Display integrierten Schaltfeld oder Schaltsymbol zugeordnet ist.

Nachteiligerweise werden die transparenten leitfähigen Strukturen des Trägermaterials mittels Leiterbahnen, Leitkleber, flexibler Leiterplatte und Stecker elektrisch mit der Auswerteelektronik verbunden. Die Leiterbahnen und die Anbindung der flexiblen Leiterplatte nehmen jedoch im Randbereich des Displays einen erheblichen Platzbedarf ein, so dass die Gesamtabmessung des Gerätes vergrößert ist, obwohl der sichtbare Bereich des Displays eine bestimmte vorgegebene Abmessung aufweist. Weiterhin ist die übliche Art der elektrischen Anbindung prozesskosten- und materialkostenintensiv, da eine Vielzahl von elektrischen Bauteilen vorzusehen und miteinander zu verbinden sind.

Zudem verlaufen die Leiterbahnen oftmals entlang aller Randseiten des Displays, wodurch die Herstellungskosten steigen, da diese Anbindungen oftmals an allen vier umlaufenden Stirnseiten vorzunehmen sind. Diese Herstellungsart ist ferner zeitintensiv.

Es ist daher Aufgabe der Erfindung, eine kapazitive Schalteinrichtung der vorgenannten Gattung bereitzustellen, die einen möglichst gering bemessenen undurchsichtigen Randbereich aufweist Dabei sollen die notwendigen Fertigungsschritte und die zu verbauenden Anbindungsteile reduziert sein.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die elektrische Verbindung zwischen dem auf der Außenseite des Displays aufgebrachten Trägermaterials und der Leiterplatte mittels eines biegeelastischen Leitgummis geschaffen ist. kann der undurchsichtige Randbereich der Schalteinrichtung erheblich reduziert werden, da der biegeelastische Leitgummi unmittelbar entlang der Außenseite des Gehäuserahmens vorbeigeführt werden kann, so dass jedes Schaltfeld des Trägermaterials mit der Leiterplatte elektrisch gekoppelt ist. Der Leitgummi kann unmittelbar elektrisch mit der Leiterplatte und den transparenten leitfähigen Strukturen des Trägermaterials verbunden sein, so dass die im Stand der Technik vorzusehenden Steck- oder Klebeverbindungen entfallen. Ferner sind die Leiterbahnanbindungen auf dem Trägermaterial und an die flexible Leiterplatte nicht notwendig.

Dadurch, dass der jeweilige Leitgummi ausschließlich an einer der Randseiten des Displays und seitlich beabstandet zu den dort vorhandenen Gehäuserahmen an diesem außenseitig vorbeigeführt ist, ist eine besonders vorteilhafte, da platzsparende, elektrische Verbindung geschaffen.

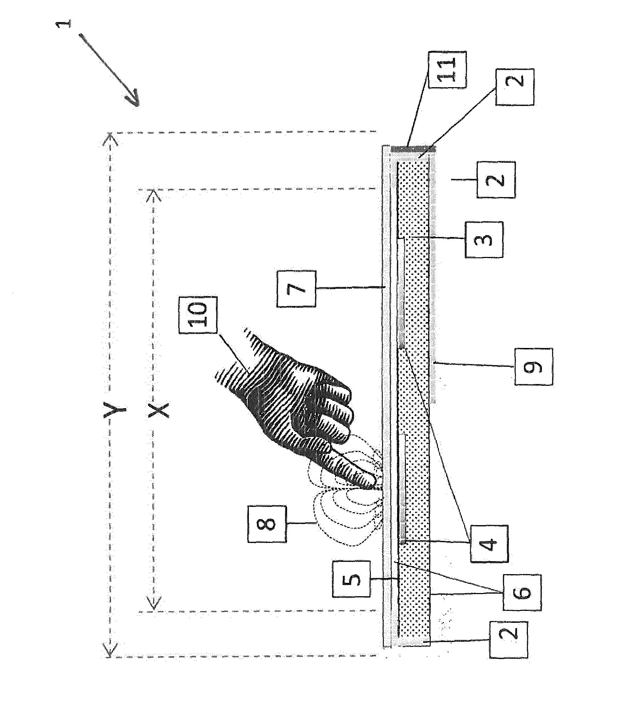

In der Zeichnung ist eine kapazitive Schalteinrichtung bestehend aus einem Gehäuserahmen, aus einem in dem Gehäuserahmen eingesetzten Display, aus einem auf dem Display aufgebrachten Trägermaterial, durch das eine Vielzahl von Spannungs- oder Kapazitätsfeldern als Schaltflächen generiert ist, und aus einer Leiterplatte, dargestellt, die nachfolgend näher erläutert ist.

Die in der einzigen Figur abgebildete Schalteinrichtung 1 besteht aus einem rechteckförmigen Gehäuserahmen 2, in dem ein Display 3 eingesetzt ist. Somit wird das Display 3 durch den Gehäuserahmen 2 gehalten und bildet ein elektrisches Gerät, beispielsweise ein Mobiltelefon, eine Bedieneinheit für Werkzeugmaschinen oder für medizintechnische Geräte.

In dem Display 3 sind eine Vielzahl von Schaltfeldern 4 integriert, die beispielsweise ein Schaltsymbol, eine Beschriftung, ein Zahlenwert oder dergleichen darstellen.

Auf der Oberfläche 5 des Displays 3 ist ein Trägermaterial 7 aufgebracht, das sowohl transparent als auch elektrisch leitfähig ist. Folglich kann das Display 3 und dessen Schaltfelder 4 von außen visuell wahrgenommen werden. Jedem Schaltfeld 4 ist dabei ein von dem Trägermaterial 7 nach außen abgestrahltes Spannungs- oder Kapazitätsfeld 8 zugeordnet. Sobald ein Objekt 10, beispielsweise ein menschlicher Finger, in das jeweilige Spannungs- oder Kapazitätsfeld 8 eindringt, wird dieses verändert. Das Objekt 10 wirkt dabei als weitere Kondensatorplatte.

Die Bestromung der Schaltfelder 4 des Trägermaterials 7 erfolgt über einen Leitgummi 11 der elektrisch mit einer Leiterplatte 9 verbunden ist, die in einem von dem Display 3 und dem Gehäuserahmen 2 gebildeten Innenraum 6 eingebaut ist. Der Leiterplatte 9 sind zudem nicht dargestellte elektrotechnische Bauteile, beispielsweise Mikroprozessoren, integrierte Schaltkreise und dergleichen, zugeordnet, durch die das Trägermaterial 7 mit Spannung versorgt ist und gleichzeitig die eingetretenen Kapazitäts-Veränderungen 8 erfassen, auswerten und in ein elektrisches Schaltsignal umwandeln. Dabei ist jede der von dem Trägermaterial 7 ausgestrahlte Kapazität 8 einem der Schaltfelder 4 des Displays 3 zugeordnet, so dass durch die elektrotechnischen Bauteile auf der Leiterplatte 9 feststellbar ist, welche Schaltsignale zu erzeugen sind, die mit dem jeweiligen angesteuerten Schaltfeld 4 des Displays 3 übereinstimmen.

Durch die Verwendung des Leitgummis 11 zur elektrischen Verbindung der Leiterplatte 9 und des Trägermateriales 7 verringert sich der Randbereich, der schematisch als Differenz der äußeren Abmessung Y und des sichtbaren Bereiches X dargestellt ist. Der unsichtbare Randbereich wird im Wesentlichen von dem Gehäuserahmen 2 und dem Leitgummi 11 gebildet.

Entweder kann folglich der sichtbare Bereich X bei einer konstanten Geräteabmessung Y vergrößert werden, oder aber die Geräteabmessung Y verringert sich unter Beibehaltung eines sichtbaren Bereiches X, wenn der Leitgummi 11 zur elektrischen Verbindung zwischen der Trägerplatte 7 und der Leiterplatte 9 verwendet ist.

## Patentansprüche

1. Kapazitive Schalteinrichtung (1) zur Umwandlung von punktuellen und/oder linearen Bewegungen eines Objektes (10) in elektrische Schaltsignale, bestehend
- aus einem Gehäuserahmen (2),
- aus einem in dem Gehäuserahmen (2) eingesetzten plattenförmigen Display (3) mit einer Vielzahl von Schaltfeldern (4),
- aus einem auf der Oberfläche (5) des Displays (3) aufgebrachten Trägermaterial (7), das transparent und elektrisch leitfähig ist und durch das ein Spannungs- oder Kapazitätsfeld (8) gebildet ist, das nach außen abstrahlt und das jedem der Schaltfelder (4) des Displays (3) zugeordnet ist und
- aus einer Leiterplatte (9), auf der Elektronikbauteile zur Auswertung der Spannungs- oder Kapazitäts-Veränderungen des Trägermaterials (7) vorgesehen sind und durch die elektrische Schaltsignale für jedes der Schaltfelder (4) generiert sind,
**dadurch gekennzeichnet,**
**dass** die elektrische Verbindung zwischen dem auf der Außenseite des Displays (3) aufgebrachten Trägermaterials (7) und der Leiterplatte (9) mittels eines biegeelastischen Leitgummis (11), vorzugsweise mittels eines Zebra-Leitgummis, geschaffen ist und dass jedes der Schaltfelder (4) des Trägermaterials (7) mittels des Leitgummis (11) an die Leiterplatte (9) angeschlossen ist.

2. Schalteinrichtung nach Anspruch 1,
**dadurch gekennzeichnet,**
**dass** der jeweilige Leitgummi (11) zwischen einer der Randseiten (12) des Displays (3) und dem Gehäuserahmen (2) oder entlang der Außenseite des Gehäuserahmens (2) geführt ist.

3. Schalteinrichtung nach einem der Ansprüche 1 oder 2,
**dadurch gekennzeichnet,**
**dass** jeweils eines der Leitgummis (11) mit einem der von dem Trägermaterial (7) gebildeten Schaltfelder (4) elektrisch verbunden ist und dass die Leitgummis (11) entlang einer der Randseiten des Gehäuserahmens (2) verlaufen.

4. Schalteinrichtung nach einem der vorgenannten Ansprüche,
**dadurch gekennzeichnet,**
**dass** der undurchsichtige Randbereich (Y-X)des Displays (3) von dem Gehäuserahmen (2) gebildet ist.

5. Schalteinrichtung nach Anspruch 4,
**dadurch gekennzeichnet,**
**dass** der undurchsichtige Randbereich des Gehäuserahmens (2) zwischen fünf und zehn Millimeter unabhängig von der Größe (X) des Displays (3) beträgt.

6. Schalteinrichtung nach einem der vorgenannten Ansprüche,
**dadurch gekennzeichnet,**
**dass** der Durchmesser des jeweiligen Leitgummis (11) etwa ein bis drei Millimeter beträgt.
